# EUROPÄISCHE PATENTSCHRIFT

(11) **EP 0 515 951 B1**
(45) Veröffentlichungstag und Bekanntmachung des Hinweises auf die Patenterteilung: **18.10.1995**
(21) Anmeldenummer: 92108413.3
(22) Anmeldetag: 19.05.1992
(51) Int. Cl.: F16B 5/00, H05K 7/14, F16B 5/06

(54) **Baugruppe aus mehreren, in parallelen Ebenen angeordneten Montageplatten**
Structural component being composed of some in parallel plains arranged mounting plates
Eléments de construction composé des plaques de montage arrangé en planes parallèles

(30) Priorität: 31.05.1991 DE 9106714 U
(43) Veröffentlichungstag der Anmeldung: 02.12.1992
(73) Patentinhaber: VDO Adolf Schindling AG, 60326 Frankfurt/Main (DE)
(72) Erfinder: Säger, Benjamin, Dipl.-Ing (FH), W-7730 Villingen-Schwenningen (DE)

(56) Entgegenhaltungen:
- EP-A- 0 156 298
- DE-A- 3 329 415
- DE-A- 3 445 576
- DE-A- 3 635 866
- DE-A- 3 838 405

## Beschreibung

Die Erfindung betrifft eine Baugruppe aus mehreren, in parallelen Ebenen angeordneten Montageplatten, welche unter Verwendung von Distanzmitteln funktionsfertig mit dem Gehäuse eines Gerätes verbindbar ist.

Wird den Gehäusen von Anzeige- und Registriergeräten lediglich eine Schutzfunktion gegen Verschmutzung und Berührung zugeordnet, so können die Festigkeitsanforderungen verringert und relativ dünne Wandstärken in Kauf genommen werden, was bei spritzgußtechnisch hergestellten Kunststoffgehäusen zu erheblich verringerten Werkzeug- und Materialkosten führt und die Standzeiten der Spritzgußformen erhöht. Bei einem derartigen Montagekonzept hat das Gehäuse nur insoweit eine tragende Funktion, als in dem Gehäuse die Funktionselemente des betreffenden Gerätes als funktionsfertige und selbsttragende Baugruppen auf einem Boden, an einem Rahmen oder auf bodenständigen Säulen befestigt werden. Auch eignet sich dieses Bauprinzip in den Fällen, in denen die betreffenden Geräte, wie beispielsweise beim Einsatz in Kraftfahrzeugen, großen Temperaturschwankungen ausgesetzt sind, dann, wenn als Träger für insbesondere miteinander in Eingriff stehende mechanische Funktionselemente metallische Montageplatten vorgesehen werden.

Soll ein derartiges Gerät in Großserie hergestellt werden, ist es andererseits zweckmäßig, nicht die Montageplatten einzeln in dem Gehäuse des Gerätes zu montieren und gegebenenfalls zumindest elektrische Verbindungen zu den einzelnen Montageplatten vorzusehen, sondern die Montageplatten zu einer Baugruppe zusammenzufassen, deren Funktion außerhalb des Gehäuses prüfbar ist, die als funktionsfertige Einheit mit dem Gehäuse verbunden oder als solche an Lager gelegt werden kann bzw. zu Reparaturzwecken als Ganzes dem Gerät entnommen werden kann.

Mit der DE-A-38 38 405 ist eine Anordnung bekannt geworden, bei der mehrere Leiterplatten einerseits mit einer rechtwinklig zu den Leiterplatten stehenden Trägerplatte fest verbunden sind, andererseits mittels schwenkbar gelagerter Riegel in ihrer Parallellage zueinander positioniert werden können. Die Befestigung der Trägerplatte an einer Wand des Gerätegehäuses erfolgt mittels Halteelemente, die mit der Wand rastend verbindbar sind. Diese Anordnung erfordert einen erheblichen konstruktiven Aufwand und eine Vielzahl von Montagearbeitsgängen und läßt sich erst im Zusammenbau mit der Wand des Gerätegehäuses als fertige Baugruppe komplettieren.

Die Aufgabe der vorliegenden Erfindung besteht somit darin, mit möglichst einfachen Mitteln eine funktionsfertige Baugruppe aus mehreren, in parallelen Ebenen angeordneten Montageplatten zu bilden, die eine großseriengerechte Montage der Baugruppe und deren Verbindung mit dem Gerätegehäuse gestattet.

Die Lösung dieser Aufgabe sieht vor, daß mehrere gleichgestaltete, mit den Montageplatten steckbar verbindbare Halter vorgesehen sind, daß an den Haltern zur Aufnahme von wenigstens zwei Montageplatten sich parallel gegenüberliegende und in Richtung der Montagebewegung verlaufende Nute ausgeformt sind, deren Breite der Dicke der Montageplatten entspricht und daß an den Montageplatten Einschnitte ausgebildet sind, deren Breite dem Abstand der sich gegenüberliegenden Nute der Halter entsprechen.

Eine bevorzugte Ausführung der Erfindung ist dadurch gekennzeichnet, daß an den Haltern jeweils wenigstens zwei Nutenpaare sowie ein mit einer Auflage mittelbar zusammenwirkender Riegel ausgebildet sind und daß in den Haltern quer zu den Nutenpaaren Öffnungen zur Durchführung von Schrauben zur Befestigung der Baugruppe in dem Gerätegehäuse ausgebildet sind.

Die gefundene Lösung bietet den Vorteil, daß eine funktionsfertige und als solche handhabbare Baugruppe aus wenigstens zwei Montageplatten lediglich durch zeitliches Zuführen und Aufstecken der erfindungsgemäßen Halter gebildet werden kann. Die Halter können spritzgußtechnisch hergestellt werden, d. h. sie stellen im Sinne der angestrebten Großserieneignung kostengünstig herstellbare Verbindungselemente dar, die unter Vermeidung von Verschraubungen und dem Auffädeln von Distanzkörpern montierbar sind und eine maßlich gut reproduzierbare Abstandshalterung für wahlweise zwei oder mehrere Montageplatten bieten. Vorteilhaft ist ferner, daß die Befestigung einer Baugruppe in einem Gerätegehäuse insofern mittels der Halter erfolgt als in diesen Durchgangsschrauben zugeordnete Öffnungen ausgebildet sind. Dadurch wird auf den Montageplatten zusätzlicher Raumbedarf für das Befestigen der Baugruppe vermieden.

Selbstverständlich ist auch eine schraubenlose und selbstsichernde Befestigung beispielsweise mit am Gerätegehäuse angeordneten, konischen Zapfen und entsprechenden Innenkonen in den Haltern oder eine Rastverbindung mittels vorzugsweise an den Haltern ausgebildeten Schnapphaken denkbar. Bei einer Verbindung der Baugruppe derart, daß die Halter durch den Boden des Gehäuses hindurchgreifen und in einer geeigneten Senkung warmgestaucht oder ultraschallverschweißt werden, kommt den Haltern zusätzlich eine Plombierfunktion zu. Die besondere Ausführungsform der Halter mit einer der Halterung einer Montageplatte dienenden Riegelverbindung gestattet es, diese in der Baugruppe außen liegende Montageplatte, beispielsweise um einen Bauteileaustausch vorzunehmen, auf einfache Weise der Baugruppe zu entnehmen und wieder zuzuführen, ohne die Halter zu entfernen.

Im folgenden sei die Erfindung anhand eines in den Zeichnungen dargestellten Ausführungsbeispiels erläutert. Es zeigen
Fig. 1 einen für die Bildung einer Baugruppe aus wenigstens zwei Montageplatten vorgesehenen Halter in einer perspektivischen Darstellung,
Fig. 2 einen in Pfeilrichtung Z in Fig. 1 betrachteten Schnitt quer zur Achse des Halters,
Fig. 3 eine Perspektive einer aus mehreren Montageplatten gebildeten Baugruppe im Zustand des Einbaus in ein Gerätegehäuse,
Fig. 4 einen Teilschnitt der im Gerätegehäuse montierten Baugruppe gemäß Fig. 3,
Fig. 5 eine Ansicht des montierten Halters in Pfeilrichtung A in Fig. 3,
Fig. 6 einen Schnitt der auf einer Ausrichtvorrichtung aufgenommenen Montageplatten gemäß der Schnittlinie X-Y in Fig. 3 zusammen mit einer Seitenansicht eines im Zustand des Zuführens dargestellten Halters.

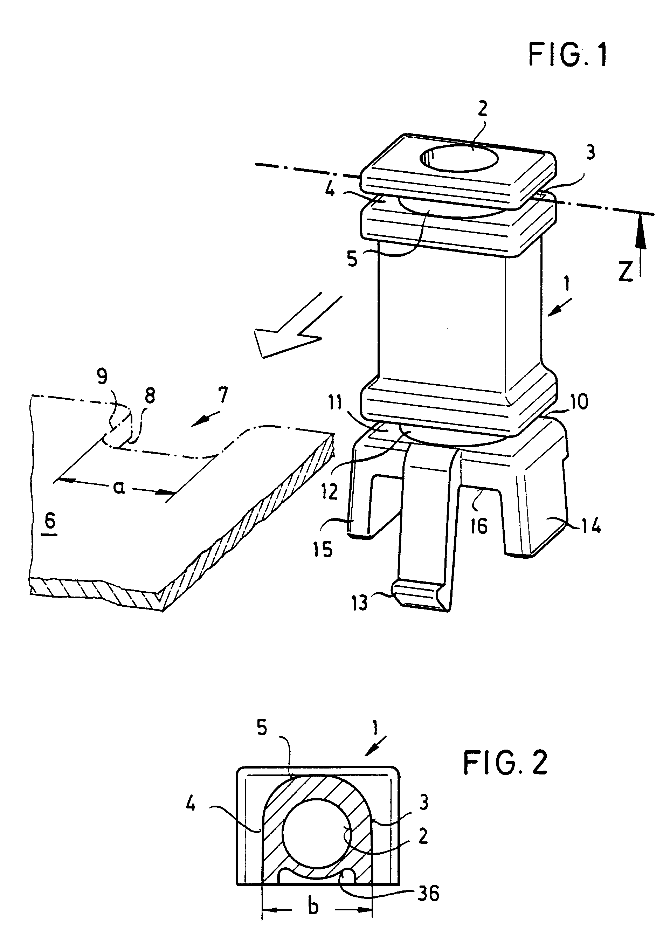

Wie die Fig. 1 zeigt, stellt der Halter 1, was den groben Umriß anbelangt, einen quaderförmigen Körper mit einer Durchgangsbohrung 2 dar. An dem einen Ende des Halters 1 sind quer zur Achse der Durchgangsbohrung 2 sich parallel gegenüberliegende Nute 3 und 4 ausgebildet. Im Falle des Ausführungsbeispieles ist der jeweilige Grund der Nute 3 und 4, wie auch aus der Fig. 2 ersichtlich ist, relativ stark in Richtung der in Montagerichtung weisenden Stirnseite des Halters 1 gerundet ausgebildet und geht in eine quer zu den Nuten 3 und 4 verlaufende, im mittleren Bereich relativ flache Verbindungsnut 5 über. Die Breite der Nute 3, 4, 5 entspricht der Dicke einer Montageplatte 6, an welcher ein der Aufnahme des Halters 1 dienender Ausschnitt 7 ausgebildet ist, und zwar derart daß dessen Breite a dem Abstand b der sich gegenüberliegenden Nute 3 und 4 entspricht, wobei vorzugsweise b gegenüber a ein Übermaß aufweist und daß die Ränder 8 und 9 des Ausschnitts 7 von dem aufgesetzten Halter 1 allseitig umgriffen sind. Bei geeigneter Passungswahl läßt sich auf diese Weise ein sicherer und beliebig fester Sitz zwischen Halter 1 und Montageplatte 6 erzielen.

In einem gewissen, axialen Abstand zu den Nuten 3, 4 und 5 ist, wie die Fig. 1 weiter zeigt, an dem Halter 1 eine weitere Nutenkombination, bestehend aus zwei parallelen Nuten 10 und 11 und einer der Verbindungsnut 5 entsprechenden und wie diese ebenfalls nicht zwingend erforderlichen Verbindungsnut 12 ausgebildet. Der zwischen den Nuten 3, 4, 5 und 10, 11, 12 liegende Bereich des Halters 1 ist aus spritzgußtechnischen Gründen, d. h. zur Vermeidung von Materialanhäufung, in geeigneter Weise eingesenkt ausgebildet. Am entgegengesetzten freien Ende des Halters 1 sind ein Riegel 13 und diesem zugeordnete Stützen 14 und 15 angeformt, die als Auflage dienen, mit der der Riegel mittelbar zusammenwirkt. Mit 16 ist die Stirnfläche des Halters 1 bezeichnet, die sozusagen die Bezugsfläche bzw. Auflagefläche des Halters 1 in einem Gerätegehäuse bildet.

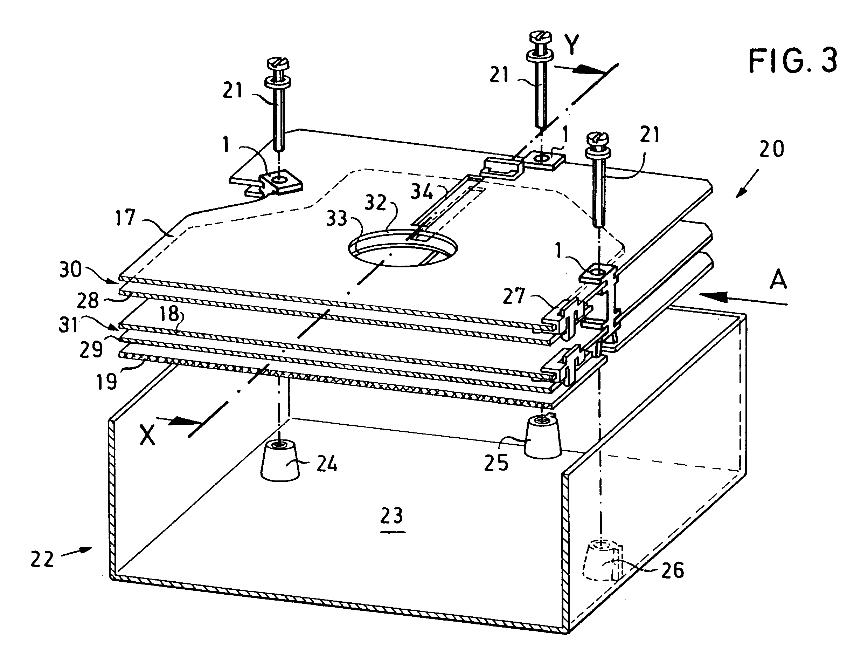

Wie aus Fig. 3 hervorgeht, wird eine aus drei Montageplatten 17, 18 und 19 bestehende Baugruppe 20 von drei Haltern 1 zusammengehalten und mittels durch die Halter 1 hindurchgreifender Schrauben 21, denen geeignete, nicht bezeichnete Unterlagscheiben zugeordnet sind, in einem Gerätegehäuse 22 befestigt, d. h. die Baugruppe 20 wird mittelbar über die Halter 1 befestigt, welche mittels der Stirnflächen 16 auf mit Gewinde versehenen, am Boden 23 des Gerätegehäuses 22 angeformten Pfosten 24, 25 und 26 aufliegen.

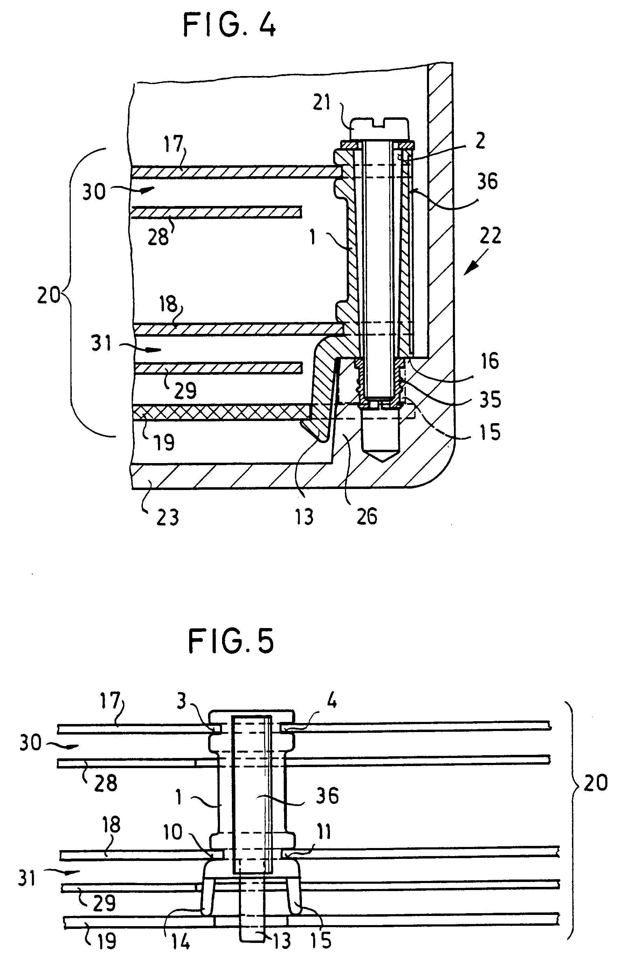

Von den Montageplatten 17, 18 und 19 stellt 19 eine Leiterplatte dar, die, wie im einzelnen besser aus den Fig. 4 und 5 ersichtlich ist, mittels der Riegel 13 und der zugeordneten Stützen 14 und 15 mit den Haltern 1 verbunden ist bzw. zwischen den Haltern 1 aufgenommen ist, während die Montageplatten 17 und 18 metallische Montageplatten darstellen, an welchen verschiedene Funktions- und Halteelemente für die Aufnahme von Antriebs- und Registriermitteln sowie anderer Bauteile in Outsert-Spritzgußtechnik angeformt sind. Der Übersicht halber sind diese nicht erfindungswesentlichen, den Montageplatten 17 und 18 und der Leiterplatte zugeordneten Bauelemente und Aufbauten nicht dargestellt.

Wie bereits angedeutet, handelt es sich bei dem dargestellten Ausführungsbeispiel um eine Baugruppe eines Registriergerätes, welches für das parallele Aufzeichnen auf zwei Aufzeichnungsträger ausgerüstet ist. Dabei sind an den Montageplatten 17 und 18 mittels angeformter Distanz- und Rastelemente, von denen eines mit 27 bezeichnet ist, Führungsplatten 28 und 29 befestigt, die zusammen mit den Montageplatten 17 und 18 Schächte 30 und 31 zur Führung der verwendeten Aufzeichnungsträger bilden. Beim Ausführungsbeispiel sind Diagrammscheiben als Aufzeichnungsträger vorgesehen, die, was ebenfalls nicht dargestellt ist, mittels senkrecht zu den Montageplatten 17 und 18 bewegbar gelagerter Zentrier- und Mitnahmedorne aufgenommen und zeitrichtig angetrieben werden. Die in der Fig. 3 dargestellten Öffnungen 32 und 33 dienen dem Durchgreifen des dem Schacht 30 zugeordneten Zentrier- und Mitnahmedorns. Selbstverständlich sind bei dem betreffenden Registriergerät Eingabe- und Entnahmeschlitze sowie geeignete Transportmittel vorgesehen, um die Aufzeichnungsträger in die Registrierposition zu transportieren und aus dieser Position wieder wegzubewegen. Ein mit 34 bezeichneter Schlitz ist für das Durchgreifen von Registrierorganen auf eine im Schacht 30 in der Registrierposition befindliche Diagrammscheibe vorgesehen.

Aus der Fig. 4, die einen Teilschnitt der im Gerätegehäuse 22 montierten Baugruppe 20 zeigt, ist ersichtlich, daß eine Bewegung der Riegel 13 in Richtung einer Entriegelung der Leiterplatte 19 durch die Pfosten 24, 25 und 26 verhindert ist und somit auch bei relativ großen, temperaturbedingten Dehnungen oder Erschütterungen eine sichere Halterung der Leiterplatte 19 gewährleistet ist. Mit 35 ist eine der Schraube 21 zugeordnete Gewindebuchse bezeichnet, während 36 eine am Halter 1 ausgeformte Kontur zur Wandstärkenverringerung darstellt.

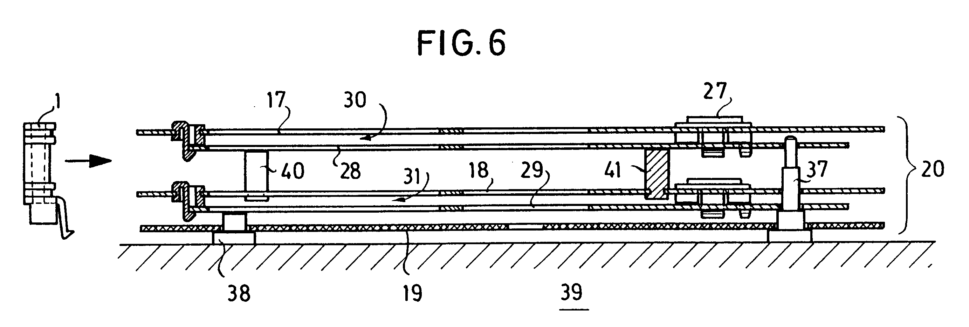

Gemäß Fig. 6 ist für den Zusammenbau der Baugruppe 20 eine Ausrichtvorrichtung vorgesehen, welche wenigstens einen Zentrier- und mehrere Auflagezapfen 37 und 38 aufweist, die in einem Werkstückträger 39 befestigt sind. Die den Haltern 1 entsprechende Parallellage der bereits vor der Bildung der Baugruppe 20 bestückten und zusammengefügten Plattenpaare 17, 28 und 18, 29 bewirken an der Montageplatte 18 angeformte Distanzkörper 40 und 41. Durch seitliches Zuführen und Aufpressen der Halter 1 wird eine selbsttragende Einheit, nämlich die Baugruppe 20, geschaffen. Diese Montagefolge ist auch maschinell durchführbar.

## Patentansprüche

1. Baugruppe aus mehreren, in parallelen Ebene angeordneten Montageplatten (17, 18), welche unter Verwendung von Distanzmitteln funktionsfertig mit dem Gehäuse (22) eines Gerätes verbindbar ist,
**dadurch gekennzeichnet,**
daß mehrere gleichgestaltete, mit den Montageplatten (17, 18) steckbar verbindbare Halter (1) vorgesehen sind,
daß an den Haltern (1) zur Aufnahme von wenigstens zwei Montageplatten (17, 18) sich parallel gegenüberliegende und in Richtung der Montagebewegung verlaufende Nute (3, 4 und 10, 11) ausgeformt sind, deren Breite der Dicke der Montageplatten (17, 18) entspricht und
daß an den Montageplatten (17, 18) Einschnitte (7) ausgebildet sind, deren Breite (a) dem Abstand (b) der sich gegenüberliegenden Nute (3, 4 und 10, 11) der Halter (1) entsprechen.

2. Baugruppe nach Anspruch 1,
**dadurch gekennzeichnet,**
daß an den Haltern (1) jeweils wenigstens zwei Nutenpaare (3, 4 und 10, 11) sowie ein mit einer Auflage (14, 15) mittelbar zusammenwirkender Riegel (13) ausgebildet sind.

3. Baugruppe nach Anspruch 1,
**dadurch gekennzeichnet,**
daß in den Haltern (1) quer zu den Nutenpaaren (3, 4 und 10, 11) Öffnungen (2) zur Durchführung von Schrauben (21) zur Befestigung der Baugruppe (20) in dem Gerätegehäuse (22) ausgebildet sind.

4. Baugruppe nach Anspruch 1,
**dadurch gekennzeichnet,**
daß die Montageplatten (17, 18) durch seitliches Aufstecken der Halter (1) miteinander verbunden werden und
daß ein paralleles Zuordnen einer Leiterplatte (19) durch Einrasten der Leiterplatte (19) zwischen die Auflagen (14, 15) und die Riegel (13) der Halter (1) erfolgt.

## Claims

1. A module comprising a plurality of mounting plates (17, 18) arranged in parallel planes, it being possible for this module to be connected to the housing (22) of a device in a manner ready for use using spacer elements, characterized in that a plurality of holders (1) of the same shape and connectable in plug-in manner to the mounting plates (17, 18) are provided, in that mutually parallel grooves (3, 4 and 10, 11) running in the direction of the mounting movement are made in the holders (1) for the purpose of receiving at least two mounting plates (17, 18), the width of the grooves (3, 4 and 10, 11) corresponding to the thickness of the mounting plates (17, 18), and in that there are made in the mounting plates (17, 18) incisions (7) whereof the width (a) corresponds to the spacing (b) between the opposing grooves (3, 4 and 10, 11) of the holders (1).

2. A module according to Claim 1, characterized in that at least two groove pairs (3, 4 and 10, 11) in each case and a catch (13) cooperating indirectly with a bearing means (14, 15) are made on the holders (1).

3. A module according to Claim 1, characterized in that openings (2) are made in the holders (1), transversely with respect to the groove pairs (3, 4 and 10, 11), for guiding through screws (21) for the purpose of securing the module (20) in the device housing (22).

4. A module according to Claim 1, characterized in that the mounting plates (17, 18) are connected to one another by laterally pushing on the holders (1) and in that a parallel association of a printed circuit board (19) is carried out by latching the printed circuit board (19) between the bearing means (14, 15) and the catches (13) of the holders (1).

## Revendications

1. Sous-ensemble constitué de plusieurs platines de montage (17, 18) disposées en des plans parallèles et pouvant être assemblé, par intercalation d'entretoises, prêt à fonctionner, avec le boitier (22) d'un appareil,
caractérisé par le fait
qu'il est prévu plusieurs supports (1) de configurations identiques pouvant être réliés par enfichage auxdites platines de montage (17, 18),
que sur lesdits supports (1) sont formées, pour loger au moins deux platines de montage (17, 18), des rainures (3, 4 et 10, 11) parallèles et opposées s'étendant dans le sens du mouvement de montage, dont la largeur correspond à l'épaisseur desdites platines de montage (17, 18) et
que sur ces platines de montage (17, 18) sont pratiquées des entailles (7) dont la largeur (a) correspond à la distance (b) des rainures opposées (3, 4 et 10, 11) des supports (1).

2. Sous-ensemble selon la revendication 1,
caractérisé par le fait
que sur les supports (1) sont respectivement formés au moins deux paires de rainures (3, 4 et 10, 11) ainsi qu'un verrou (13) coopérant indirectement avec un appui (14, 15).

3. Sous-ensemble selon la revendication 1,
caractérisé par le fait
que dans les supports (1) sont formées, transversalement aux paires de rainures (3, 4 et 10, 11), des ouvertures (2) pour le passage de vis (21) en vue de la fixation du sous-ensemble (20) dans le boîtier d'appareil (22).

4. Sous-ensemble selon la revendication 1,
caractérisé par le fait
que les platines de montage (17, 18) sont assemblées l'une avec l'autre par l'enfichage latéral des supports (1) et qu'une association parallèle d'une platine à circuits imprimés (19) est réalisée par enclenchement de ladite platine de montage (19) entre les appuis (14, 15) et les verrous (13) des supports (1).
